Europäisches Patentamt

European Patent Office

Office européen des brevets

(11) Veröffentlichungsnummer: **0 123 863**
**B1**

(12) **EUROPÄISCHE PATENTSCHRIFT**

(45) Veröffentlichungstag der Patentschrift:
18.01.89

(51) Int. Cl.⁴: **C 30 B 13/32**, C 30 B 13/00

(21) Anmeldenummer: **84102995.2**

(22) Anmeldetag: **19.03.84**

(54) Bandförmige Folien aus Metallen, Verfahren und Vorrichtung zu deren Herstellung sowie ihre Verwendung.

(30) Priorität: 31.03.83 DE 3311891

(43) Veröffentlichungstag der Anmeldung:
07.11.84 Patentblatt 84/45

(45) Bekanntmachung des Hinweises auf die Patenterteilung:
18.01.89 Patentblatt 89/3

(84) Benannte Vertragsstaaten:
BE DE FR GB IT NL

(56) Entgegenhaltungen:
FR-A- 2 486 925
US-A- 3 117 859

APPLIED OPTICS, Band 19, Nr. 6, März 1980, Seiten
909-913, Optical Society of America, New York, US; A.
BAGHDADI et al.: "Silicon ribbon growth using scanned
lasers"
APPLIED PHYSICS LETTERS, Band 40, Nr. 8, 15. April
1982, Seiten 698-700, American Institute of Physics,
New York, US; D. CASENAVE et al.: "Silicon ribbon
growth using electron bombardment"
JOURNAL OF APPLIED PHYSICS, Band 37, Nr. 4, 15.
März 1966, Seiten 1929,1930; S. NAMRA:
"Crystallization of vacuum-evaporated germanium
films by the electron-beam zone-melting process"
(73) Patentinhaber: BAYER AG, Konzernverwaltung RP
Patentabteilung, D-5090 Leverkusen 1 Bayerwerk (DE)

(72) Erfinder: Schwirtlich, Ingo, Dr., St. Antonstrasse 231,
D-4150 Krefeld (DE)
Erfinder: Woditsch, Peter, Dr., Deswatinesstrasse 83,
D-4150 Krefeld (DE)

## Beschreibung

Die vorliegende Erfindung betrifft bandförmige Folien aus Metallen, ein Verfahren zur Kristallisation dieser Folien sowie eine Vorrichtung zur Durchführung des Verfahrens.

Die Herstellung von Solarzellen geschieht üblicherweise aus kristallinem Silicium in Band- oder Scheibenform von einigen 100 µm Dicke.

Die Herstellung dieser Scheiben oder Bänder kann durch Zerteilen eines gegossenen Siliciumblockes, Ziehen von Folien geeigneter Dicke aus der Schmelze oder Sintern von Bändern aus pulverförmigem Rohmaterial mit und ohne Bindemittel erfolgen.

Eine Kornvergrösserung polykristalliner Bänder lässt sich durch eine Wärmebehandlung erreichen. Dazu wird das Band bei den bekannten Verfahren durch eine Zone erhöhter Temperatur bewegt, wobei der Schmelzpunkt des Materials jedoch nicht überschritten wird (DE-A 3 019 654).

In anderen Verfahren, die sich ebenfalls zur Vergrösserung von Kristallkörnern eignen, wird das Band mit Hilfe eines geführten Elektronen- oder Laserstrahls örtlich aufgeschmolzen (FR-A 2 486 925; EP-A 47 140; DE-A 3 100 818; J. of Electronic Mat. Vol. 9, No. 5, 1980, 841–856; Applied Optics, Vol. 19, No. 6, 1980, 909–913; Applied Physics letters, Vol. 40, No. 8, 1982, 698–700).

Nach beiden Methoden kann ein Siliciumband in Zeilen fortlaufend aufgeschmolzen werden. Die Verwendung von Elektronenstrahlen bringt den Nachteil mit sich, dass sich die gesamte Anordnung im Vakuum befinden muss.

Es ist weiterhin bekannt, dass die Verunreinigungskonzentration in Kristallen durch Zonenschmelzen verringert werden kann (EP-A 54 656). Dabei wird eine Schmelzzone, die den gesamten Querschnitt des Stabes durchdringt, den Stab entlanggeführt. Die Fremdatome, die sich in dem Kristall befinden, reichern sich dabei in der flüssigen Phase entsprechend ihres Segregationskoeffizienten an. Dieses Verfahren lässt sich nicht auf die kontinuierliche Reinigung von Bändern anwenden (E. Sirtl. Proc. of Photovollaic Solar Energy Conf., Stresa 10–14 May 1982, 858 ff), da die Reinigungswirkung eine Sättigung erfährt, sobald die Konzentrationen der Verunreinigungen in der flüssigen Phase ihren Sättigungswert erreicht haben.

Eine Zonenreinigung von Bändern ist damit auf relativ geringe Bandlängen von einigen Zentimetern begrenzt. Durch eine mehrfache Wiederholung liessen sich auf diese Weise nur wenig längere Bänder reinigen.

Wird das Band, wie im Falle des Zonenschmelzens an Stäben, über seinen Querschnitt vollständig aufgeschmolzen, ergibt sich daraus eine maximale Begrenzung der Bandbreite, die durch die Oberflächenspannung der Schmelze bestimmt wird. Eine Überschreitung dieses Wertes würde zu einer Kontraktion der Schmelzzone und damit zu einer Zerstörung der Bandstruktur führen.

Ziel der Erfindung ist es daher, ein Verfahren und eine Vorrichtung zu schaffen, um Bänder oder Folien aus Metallen, Halbmetallen oder Halbleitermaterialien wirtschaftlich kontinuierlich zu kristallisieren, zu rekristallisieren und zu reinigen.

Die gestellte Aufgabe wird dadurch gelöst, dass man mehrere lokal begrenzte Schmelzzonen erzeugt, die sich nicht gegenseitig überlappen, die Schmelzzonen verlaufen dabei nicht in Ziehrichtung der bandförmigen Folien.

Gegenstand der vorliegenden Erfindung ist somit ein Verfahren zur Rekristallisation und Reinigung von bandförmigen Folien aus Metallen, Halbmetallen oder Halbleitermaterialien, bei dem mehrere lokal begrenzte Schmelzzonen erzeugt werden, die sich nicht gegenseitig überlappen und die nicht in Ziehrichtung der bandförmigen Folien verlaufen.

Besonders bevorzugt ist dabei eine Verfahrensweise, bei der die bandförmigen Folien kontinuierlich bewegt werden. In einer besonders bevorzugten Ausführungsform des erfindungsgemässen Verfahrens führt man eine Heizquelle quer zur Zugrichtung der bandförmigen Folien, wodurch die Schmelzzonen einen Winkel grösser als 0° und kleiner ±90°, bevorzugt zwischen 30 und 60°, zur Zugrichtung der bandförmigen Folie oder der Heizquelle durchläuft.

Besonders interessant ist das erfindungsgemässe Verfahren für die Reinigung von Folien aus Silicium oder Germanium.

Die Längskomponente der Bewegung kann dabei durch einen Transport der bandförmigen Folie und die Querkomponente durch die Bewegung der Wärmequelle bewirkt werden. Bei der Wärmequelle kann es sich um eine widerstandsbeheizte oder eine induktiv beheizte Wendel handeln, die in geringem Abstand über dem Band (1–4 mm) quer zu dessen Hauptrichtung angebracht ist.

Die vorliegende Erfindung betrifft auch eine Vorrichtung zur Erzeugung mehrerer Schmelzzonen, die sich nicht gegenseitig überlappen, wobei eine widerstands- und/oder induktiv beheizte Wendel eingesetzt wird. Diese Wendel kann aus Graphit oder Siliciumcarbid oder auch ein Draht oder Band aus hochschmelzendem Material wie Molybdän, Wolfram, Tantal oder Niob sein. Diese Metalldrähte können auf einem Träger aufgewickelt sein.

Gegenstand dieser Erfindung ist somit eine Vorrichtung zur Kristallisation von Metallfolien, bestehend aus einem streifenförmigen wendelförmigen Heizleiter (1), der gegebenenfalls auf ein geteiltes Keramikrohr (2) aufgewickelt ist, wobei die Enden des Heizleiters mit je einem Drehteil (3) verbunden sind, das eine Befestigung (9) des wendelförmigen Heizleiters (1) ermöglicht, und die Drehteile mitsamt der Wendelheizung (1, 2) über die Antriebsachsen (4) in einer Halterung (50) drehbar gelagert sind.

In einer bevorzugten Ausführungsform besteht der Heizleiter (1) aus Graphit oder Siliciumcarbid oder ist ein Draht oder Band aus hochschmelzendem Material wie Molybdän, Wolfram, Tantal oder Niob.

Durch die Wärmestrahlung der bandnahen Windungsteile wird die Metall- oder Halbleiterfolie lokal aufgeschmolzen. Die Schmelzzonen werden durch die Oberflächenspannung des Materials stabilisiert. Wird die Heizwendel um ihre Längsachse gedreht, dann wandern die Schmelzzonen parallel zur Wendelachse an den Rand der Folie. Die Richtung dieser Wanderung wird durch die Drehrichtung der Wendel bestimmt. Wird die Folie unter der Wendel durchbewegt, dann ergibt sich die Bewegungsrichtung der Schmelzzonen als Resultierende beider Richtungen.

Die Folie oder auch kontinuierlich aufeinanderfolgende Scheiben werden auf diese Weise streifenförmig schräg zur Hauptbewegungsrichtung aufgeschmolzen. Die dazwischenliegenden nicht aufgeschmolzenen Streifen können entweder durch eine zweite gleichartige Vorrichtung oder einen zweiten Durchgang des Bandes aufgeschmolzen werden, so dass insgesamt die gesamte Breite des Bandes überstrichen wird. Das Band kann auf diese Weise vollständig aufgeschmolzen und kristallisiert werden, wobei durch die gerichtete Führung der Schmelzzonen eine Reinigungswirkung erzielt wird.

Nachdem die Folie das erfindungsgemässe Verfahren durchlaufen hat, weist sie an ihrer Oberfläche eine den Schmelzpfaden entsprechende Struktur auf, die für diese Art der Behandlung charakteristisch ist.

Gegenstand der vorliegenden Erfindung sind somit auch bandförmige Folien, die nach dem erfindungsgemässen Verfahren erhalten werden.

Die vorliegende Erfindung weist gegenüber einem Verfahren, das sich eines geführten Laser- oder Elektronenstrahls bedient, den Vorteil auf, dass sich problemlos relativ grosse lokal begrenzte Schmelzzonen dadurch erzeugen lassen, dass eine entsprechend breite Heizwendel gewählt wird. Auf diese Weise erzeugte Schmelzzonen werden in ihrer Ausdehnung nur durch die Oberflächenspannung der Schmelze begrenzt, die für die Stabilisierung der Schmelzzone verantwortlich ist. Schmelzzonen von 50 mm Durchmesser sind daher denkbar. Im Gegensatz dazu können durch Elektronen- oder Laserstrahen nur Schmelzzonen von wenigen Millimetern Durchmesser erzeugt werden.

Ein weiterer Vorteil des erfindungsgemässen Verfahrens besteht darin, dass zur Erhöhung der Zahl der Schmelzzonen nur die Windungszahl der Heizwendel erhöht werden muss.

Beide Vorteile zusammen haben zur Folge, dass die Geschwindigkeit mit der das zu kristallisierende Band die erfindungsgemässe Vorrichtung passiert so niedrig gewählt werden kann, dass die mit der Bewegung der Schmelzzone verbundene Reinigungswirkung unter wirtschaftlichen Gesichtspunkten noch voll zum Tragen kommt.

Ein weiterer Vorteil dieses Verfahrens ist in seinem günstigeren Wirkungsgrad zu sehen, wenn man mit dem Strahl eines Lasers oder einer Elektronenstrahlkanone vergleicht. Der Wirkungsgrad dieses Verfahrens wird wesentlich durch die Wärmeisolation der nicht auf die bandförmige Folie einwirkenden Wendelteile bestimmt. Er kann deshalb entsprechen optimiert werden. Die nicht direkt auf die Folie einwirkenden Wendelteile tragen zur Erwärmung der bis auf einen Ein- und Ausgang für die Folie thermisch gut isolierten Kammer bei, in der diese Vorrichtung installiert ist. Die mittlere Temperatur dieser Kammer sollte so hoch liegen, dass die beim lokalen Aufschmelzen entstehenden mechanischen Spannungen nicht zu einer Zerstörung des Bandes führen.

Beim erfindungsgemässen Verfahren besteht die Möglichkeit, mit Hilfe eines Impfkristalls am Anfang des Bandes eine Vorzugsorientierung in das Band einzutragen.

Während Verfahren, die sich eines Elektronenstrahls bedienen, nur im Vakuum angewendet werden können, ist das erfindungsgemässe Verfahren bei entsprechender Wahl des Heizwendelmaterials sogar an Luft durchführbar.

Bisher wurde von einer Anordnung ausgegangen, bei der die Heizwendel nur auf einer Seite, der Oberseite, des Bandes angeordnet ist. Für dickere Folien, Scheiben oder Bänder kann diese Vorrichtung so erweitert werden, dass auf beiden Seiten des aufzuschmelzenden Bandes eine Heizwendel angebracht ist, deren Drehzahl und Drehrichtung aufeinander abgestimmt sind.

Die Halterung und der Transport der zu kristallisierenden Bändern während des Aufschmelzens ist für das erfindungsgemässe Verfahren ohne besondere Bedeutung, solange sichergestellt ist, dass eine Verunreinigung der geschmolzenen Bereiche nicht erfolgen kann. Diese Forderung lässt sich auf verschiedenem Wege erfüllen, z.B. dadurch, dass im Fall einer Siliciumfolie ein Tragekörper aus einem mit flüssigen Silicium nicht reagierenden Material wie Siliciumnitrid, Siliciumcarbid oder Graphit gewählt wird oder durch eine entsprechende Anordnung der tragenden Teilen eine Berührung zwischen den bandführenden Teilen und dem flüssigen Silicium verhindert wird. Für den Fachmann ergeben sich verschiedene Lösungsmöglichkeiten, die den Erfindungsgedanken selbst nicht betreffen. So könnte das Band oder die Folie beispielsweise so unter der Heizwendel hindurchgeführt werden, dass es nur vor und hinter der momentanen Schmelzzone aufliegt.

Eine weiter Verbesserung des erfindungsgemässen Verfahrens kann durch die Verringerung thermischer Spannungen zwischen den aufgeschmolzenen Bereichen, dem festen Metall- oder Halbleiter und dem Trägermaterial erreicht werden. Nach einer Ausführungsform der Erfindung wird beispielsweise der gesamte aufzuschmelzende Bandabschnitt auf eine höhere Temperatur gebracht, bevor die einzelnen Schmelzzonen erzeugt werden. Die Temperaturen, die dabei eingestellt werden sollen, erwiesen sich als wenig kritisch, wenn sie oberhalb 600 °C, vorzugsweise oberhalb 700 °C lagen. Die obere Grenze wird selbstverständlich durch die Schmelztemperatur des Siliciums gebildet. Um definierte Schmelzzonen mit der erfindungsgemässen Anordnung zu erzeugen und möglichst wirtschaftlich zu arbeiten werden Temperaturen unterhalb der Sintertemperatur der zu kristallisierenden Metalle und Halbleitermaterialien bevorzugt verwendet.

Im Fall von Silicium erwiesen sich Temperaturen der Bänder von 600°C bis 1200°C, vorzugsweise zwischen 800°C bis 1000°C, als gut geeignet. Der Aufbau und Abbau dieser Temperaturen vor bzw. nach dem eigentlichen Kristallisationsschritt sind unkritisch, solange keine extrem hohen Heiz- und Kühlraten angewendet werden, Temperaturänderungen bis zu einigen 100°C pro Minute können dabei verkraftet werden.

Der Transport der bandförmigen Folien kann auf verschiedene Weise erfolgen. Er ist für das erfindungsgemässe Kristallisationsverfahren ohne Bedeutung, solange eine gleichmässige Bewegungsgeschwindigkeit eingehalten wird. Sowohl das Ziehen der Bänder als auch ein Transport über Trägervorrichtungen führen zu gleichen Ergebnissen hinsichtlich der gewünschten Kristallisation und Reinigung.

Die nachfolgenden Beispiele sollen die Erfindung verdeutlichen, ohne jedoch eine Einschränkung darzustellen.

Fig. 1 betrifft die Darstellung der Vorrichtung zur Erzeugung lokal begrenzter Schmelzzonen und deren Bewegung durch eine Metallfolie.

Fig. 2 ist eine schematische Darstellung des durch das streifenförmige Aufschmelzen erhaltenen Kristallisationsmuster.

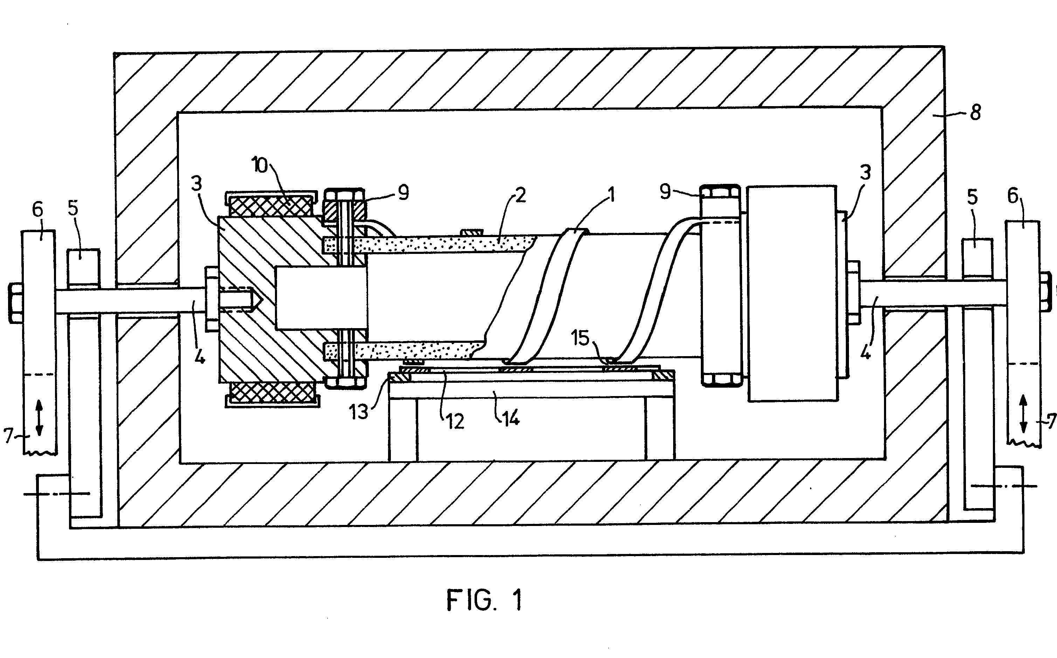

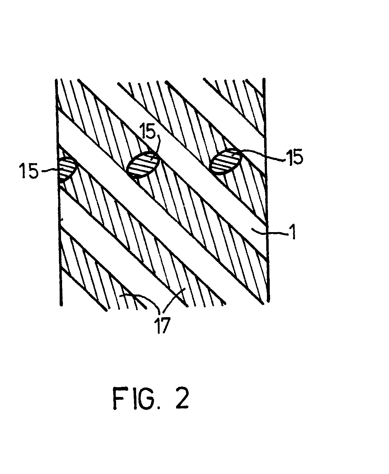

Die Bedeutung der Zahlen in den Darstellungen Fig. 1 und Fig. 2 ist den folgenden Beispielen zu entnehmen.

Beispiel 1

Die zur Kristallisation verwendete Vorrichtung besteht wie in Fig. 1 dargestellt aus einem streifenförmigen Molybdänblech (1) mit einer Breite von 5 mm und einer Dicke von 0,6–0,8 mm, das auf ein geteiltes Keramikrohr (2) mit einem Aussendurchmesser von 32 mm zu einer Wendel aufgewickelt ist.

Die Wendelsteigung beträgt zwischen 10 und 30 mm. Das Keramikrohr ist an seinen Enden mit je einem Drehteil (3) verbunden, das eine Befestigung (9) des Molybdänbleches (1) ermöglicht. Über dieses Drehteil aus Kupfer wird mittels der Kohlenbürsten (10) der Heizstrom zugeführt.

Die Drehteile (3) werden mitsamt der Wendelheizung (1), (2) über die Antriebsachsen (4) in der Halterung (5) gelagert. Zu Vermeidung von belastenden Drehmomenten werden beide Halbachsen über eine äussere Verbindungswelle (nicht gezeichnet) mit Hilfe der Zahnriemenscheiben (6) und der Zahnriemen (7) von einem Motor (nicht gezeichnet) angetrieben. Die Lager (5) sowie der gesamte Antriebsmechanismus befinden sich ausserhalb eines Gehäuses (8), das der thermischen Isolation dient. Es ist nur an seiner Front- und Rückseite mit einer Öffnung versehen, die dem Zu- und Abtransport der zu kristallisierenden Folien dient.

Diese Vorrichtung wird verwendet, um eine polykristalline Siliciumscheibe von 50 mm × 50 mm × 0,4 mm (12) örtlich begrenzt aufzuschmelzen.

Dazu liegt die Scheibe auf Keramikschienen auf (13), die sich auf einer weiteren Heizung (14) befinden. Die Schienen sind unterhalb der Heizwendel unterbrochen, so dass kein schmelzflüssiges Silicium in Kontakt mit diesen Halterungen kommen kann. Der Abstand zwischen Heizwendel (2) und Siliciumscheibe (12) kann durch die um (15) schwenkbare Halterung (5) der Wendel (2) eingestellt werden.

Die gesamte Anordnung mit Ausnahme des temperaturempfindlichen Antriebs (6), (7) sowie der Halterung (5) ist von einem Isolationsgehäuse (8) umgeben, um die aufzuwendende Energie so gering wie möglich zu halten. Als Atmosphäre wurde Argongas verwendet. Mit Hilfe der Graphitheizung (14) wurde die Temperatur im Isolationsgehäuse (8) soweit erhöht, dass die Siliciumscheibe einer Temperatur von 800°C ausgesetzt wurde. Darauf wurde durch direkten Stromdurchgang die Molybdänwendel so stark erhitzt, dass die wendelnahen Bereiche (15) der Siliciumscheibe (12) aufgeschmolzen wurden. Dazu war eine Leistung von ca. 3 kW erforderlich. Die Wendel wurde daraufhin in Rotation versetzt (1–3 min$^{-1}$) und die Siliciumscheibe mit einer Geschwindigkeit von ca. 3 mm/s darunter hindurchgezogen. Dies führte zu einem streifenförmigen Aufschmelzen in Richtung der Bewegungsresultierenden (Fig. 2). Die Streifenbreite hängt von der Wendeltemperatur und der resultierenden Geschwindigkeit ab. In diesem Experiment ergab sich eine Streifenbreite von 8 mm (17). Die aufgeschmolzenen Bereiche zeigten anschliessend nur noch wenige grosse Kristallkörner.

Beispiel 2

Durch Anpassung des Teils 9 an eine Graphitwendel mit 20 mm Aussendurchmesser, einer Wandstärke von 2 mm und einer Windungsbreite von 10 mm wurde ein polykristalline Siliciumscheibe lokal aufgeschmolzen. Die Steigung der Wendel betrug 30 mm. Eine Siliciumscheibe (12) mit den Abmessungen 50 mm × 50 mm × 0,4 mm wurde auf 820°C mit Hilfe der Heizung (14) erwärmt. Der Abstand der Heizwendel zur Siliciumscheibe betrug 2 mm. Das Aufheizen der Wendel mit 1500 W führt zur Ausbildung von Schmelzzonen in den windungsnahen Bereichen. Durch Rotation der Wendel mit 1–3 min$^{-1}$ und Verschieben der Siliciumscheibe mit 1–3 mm/s wurde ein streifenförmiges Aufschmelzen wie im ersten Beispiel erreicht. Auch hier betrug die Streifenbreite ca. 8 mm. Sie liess sich durch Erhöhen der Heizleistung bis auf 15 mm verbreitern.

Beispiel 3

In die unveränderte Vorrichtung des Beispiels 2 wurden Siliciumfolien eingesetzt, die aus einer Aufschlämmung von feinteiligem Siliciumpulver bestanden. Die Folienbreite betrug 50 mm, die Dicke 0,2 mm. Diese Folien wurden in gleicher Weise wie die Siliciumscheiben der vorangegangenen Beispiele durch Auflegen auf Keramikschienen (13) an den Rändern gehalten. Durch eine Unterbrechung im Bereich der Wendelheizung (1) wurden die Folien dadurch freitragend gelagert, so dass hier keine Aufnahme von Verunreinigungen durch Kontaktieren der Schmelze mit dem Trägermaterial auftreten konnte. Nach einer Vorwärmung der Folie auf 400°C mit Hilfe von Heizung (14) wurde sie durch die Heizwendel lokal begrenzt aufgeschmolzen. Die dazu erforderliche Leistung betrug ca. 2,3 kW.

Ein Rotieren der Wendel mit bis zu 10 Umdrehungen pro Minute führte zu einem streifenförmigen Aufschmelzen, wenn die Folie mit einer Geschwindigkeit bis zu 5 mm/s unter der Wendel hindurchgezogen wurde. Nach der Erstarrung wiesen die aufgeschmolzenen Streifen grössere einkristalline Bereiche auf, deren Grösse von der Geschwindigkeit der Schmelzzone, ihrer Temperatur und dem Verunreinigungsgehalt des Folienmaterials abhing.

**Patentansprüche**

1. Verfahren zur Rekristallisation und Reinigung von bandförmigen Folien aus Metallen, Halbmetallen oder Halbleitermaterialien, bei dem mehrere lokal begrenzte Schmelzzonen erzeugt werden, die sich nicht gegenseitig überlappen und die nicht in Ziehrichtung der banförmigen Folien verlaufen.

2. Verfahren gemäss Anspruch 1, dadurch gekennzeichnet, dass die bandförmigen Folien kontinuierlich bewegt werden.

3. Verfahren gemäss Anspruch 1, dadurch gekennzeichnet, dass eine Heizquelle ein Bewegung quer zur Zugrichtung der bandförmigen Folien durchläuft und damit die Schmelzzonen einen Winkel grösser als 0° und kleiner ±90°C, bevorzugt zwischen 30 und 60°, zur Zugrichtung der bandförmigen Folie oder der Heizquelle durchläuft.

4. Verfahren gemäss einem der Ansprüche 1 bis 3, dadurch gekennzeichnet, dass das Halbmetall Silicium oder Germanium ist.

5. Verfahren gemäss einem der Ansprüche 1 bis 3, dadurch gekennzeichnet, dass die Schmelzzonen durch Strahlungseinwirkung oder durch Einwirkung höherer Temperaturen erzeugt werden.

6. Vorrichtung zur Kristallisation von Metallfolien, bestehend aus einem streifenförmigen wendelförmigen Heizleiter (1), der gegebenenfalls auf ein geteiltes Keramikrohr (2) aufgewickelt ist, wobei die Enden des Heizleiters mit je einem Drehteil (3) verbunden sind, das eine Befestigung (9) des wendelförmigen Heizleiters (1) ermöglicht, und die Drehteile mitsamt der Wendelheizung (1, 2) über die Antriebsachsen (4) in einer Halterung (5) drehbar gelagert sind.

7. Vorrichtung gemäss Anspruch 6, dadurch gekennzeichnet, dass der Heizleiter (1) aus Graphit oder Siliciumcarbid besteht oder ein Draht oder Band aus hochschmelzendem Material wie Molybdän, Wolfram, Tantal, oder Niob ist.

8. Bandförmige Folien, die nach einem oder mehreren der Ansprüche 1 bis 5 erhalten werden.

9. Verwendung von bandförmigen Folien gemäss Anspruch 8 zur Herstellung von Solarzellen.

**Claims**

1. Process for the recrystallisation and purification of foils of metals, semi-metals or semiconductor materials in the form of strips, in which several locally confined melting zones are produced which do not overlap one another and do not extend in the direction of drawing of the strips of foil.

2. Process according to claim 1, characterised in that the foils in the form of strips are kept in continuous motion.

3. Process according to claim 1, characterised in that a source of heating passes through a movement extending transversely to the direction of drawing of the foils in the form of strips so that the melting zones pass through an angle greater than 0° and les than ±90°, preferably from 30 to 60°, to the direction of drawing of the strips of foil or the heating source.

4. Process according to one of the claims 1 to 3, characterised in that the semi-metal is silicon or germanium.

5. Process according to one of the claim 1 to 3, characterised in that the melting zones are produced by the action of radiation or elevated temperatures.

6. Apparatus for the crystallisation of metal foils, consisting of a spiral heating conductor (1) in the form of a strip which is optionally wound on a divided ceramic tube (2), the ends of the heating conductor being each connected to a rotary part (3) enabling the spiral heating conductor (1) to be fixed (9), and the rotary parts together with the spiral heating means (1, 2) being rotatably mounted in a holder (5) by means of the drive shafts (4).

7. Apparatus according to claim 6, characterised in that the heating conductor (1) consists of graphite or silicon carbide or of a wire or strip of a high melting material such as molybdenum, tungsten, tantalum or niobium.

8. Foils in the form of strips obtained according to one or more of claims 1 to 5.

9. Use of the foils in the form of strips according to claim 8 for the production of solar cells.

**Revendications**

1. Procédé de recristallisation et de purification de feuilles en forme de rubans de métaux, métalloïdes ou matières semiconductrices, dans lequel sont produites plusieurs zones de fusion limitées localement qui ne se recouvrent pas mutuellement et ne s'étendent pas dans la direction de traction des feuilles en rubans.

2. Procédé suivant la revendication 1, caractérisé en ce que les feuilles sous forme de rubans, sont mues en continu.

3. Procédé suivant la revendication 1, caractérisé en ce qu'une source de chaleur exécute un mouvement transversalement à la direction de traction des feuilles en forme de rubans et par conséquent les zones de fusion parcourent un angle supérieur à 0° et inférieur à ±90°, de préférence compris entre 30 et 60°, par rapport à la direction de traction de la feuille en forme de ruban ou à la source de chaleur.

4. Procédé suivant l'une des revendications 1 à 3, caractérisé en ce que le métalloïde est du silicium ou du germanium.

5. Procédé suivant l'une des revendications 1 à 3, caractérisé en ce que les zones de fusion sont produites par l'action d'un rayonnement ou par l'action de températures élevées.

6. Dispositif pour la cristallisation de feuilles métalliques, constitué d'un conducteur thermique (1) hélicoïdal en form de bande, qui est éventuellement enroulé sur un tube céramique (2) divisé, les extrémités du conducteur chauffant étant reliées chacune avec une pièce tournante (3) qui permet une fixation (9) du conducteur chauffant (1) hélicoïdal, et les pièces tournantes sont montées de manière à pouvoir tourner conjointement avec le système chauffant hélicoïdal (1, 2), par l'intermédiaire d'axes d'entraînement (4) dans un support (5).

7. Dispositif suivant la revendication 6, caractérisé en ce que le conducteur chauffant (1) est réalisé en graphite ou en carbure de silicium ou est un film métallique ou un ruban en métal à haut point de fusion tel que molybdène, tungstène, tantale ou niobium.

8. Des feuilles en forme de ruban qui sont obtenues suivant une ou plusieurs des revendications 1 à 5.

9. Utilisation de feuilles en forme de ruban suivant la revendication 8 pour la fabrication de cellules solaires.

FIG. 1

EP 0 123 863 B1

FIG. 2